# EUROPÄISCHE PATENTANMELDUNG

(11) **EP 0 899 794 A2**
(43) Veröffentlichungstag der Anmeldung: **03.03.1999**
(21) Anmeldenummer: 98115023.8
(22) Anmeldetag: 10.08.1998
(51) Int. Cl.: H01L 29/872

(54) **Hochfrequenzdiode und Verfahren zu deren Herstellung**

(30) Priorität: 27.08.1997 DE 19737360
(71) Anmelder: SIEMENS AKTIENGESELLSCHAFT, 80333 München (DE)
(72) Erfinder: Losehand, Reinhard, 80637 München (DE); Werthmann, Hubert, 81247 München (DE)

(57) **Zusammenfassung**

Hochfrequenzdiode, bei der in einem hochohmigen Siliziumsubstrat (1) eine n- oder p-leitend dotierte Wanne (2) ausgebildet ist. Über einem ersten Teilbereich (3) einer Oberfläche (4) der Wanne (2) ist Silizium-Epitaxieschicht (5) vorgesehen, die denselben Leitungstyp wie die dotierte Wanne (2) aufweist. Die Silizium-Epitaxieschicht (5) ist einer ersten Schottky-Kontaktschicht (6) und ein neben dem ersten Teilbereich (3) liegender zweiter Teilbereich (7) der Oberfläche (4) der Wanne (2) ist mit einer zweiten Schottky-Kontaktschicht (8) versehen, auf die eine erste (9) bzw. eine zweite Kontaktmetallisierung (10) aufgebracht ist.

## Beschreibung

Die Erfindung bezieht sich auf eine Hochfrequenzdiode, insbesondere zur Verwendung bei Frequenzen oberhalb von 20 GHz und mit einer parasitären Kapazität von unter 50 fF.

Bislang beispielsweise aus Zinke/Brunswig, Lehrbuch der Hochfrequenztechnik, 3. Auflage, 2. Band, Springer-Verlag, Berlin, 1987, S. 58 oder Microwave Semiconductors, Short Form Catalog 1988/89, Seiten 10 und 11,bekanntgewordene Hochfrequenzdioden werden mittels Beam-Lead-Technologie hergestellt, bei der zwischen einem Silizium-Substrat und einer Kontaktmetallisierung zur Diodenstruktur hin eine Sinterglasschicht angeordnet ist. Diese Art von Hochfrequenzdioden sind daher mit großem Fertigungsaufwand verbunden. Darüberhinaus ist die Montage dieser Hochfrequenzdioden nicht mit herkömmlichen in der Halbleiter-Mikro-elektronik verwendeten Bestückungsautomaten durchführbar.

Die Aufgabe der vorliegenden Erfindung besteht darin, Hochfrequenzdioden mit einer parasitären Kapazität von unter 50 fF zu entwickeln, die einen geringen Herstellungsaufwand erfordern und die mit herkömmlichen in der Halbleitertechnik verwendeten automatisierten Bestückungsanlagen montierbar sind.

Diese Aufgabe wird durch eine Hochfrequenzdiode mit den Merkmalen des Anspruches 1 gelöst. Vorteilhafte Weiterbildungen der erfindungsgemäßen Hochfrequenzdiode sind Gegenstand der Unteransprüche 2 bis 5. Ein bevorzugtes Verfahren zum Herstellen der Hochfrequenzdiode ist Gegenstand des Unteranspruches 6.

Erfindungsgemäß ist vorgesehen, dass in einem hochohmigen Siliziumsubstrat, dessen spezifischer Widerstand bevorzugt größer als 3 kΩcm ist, eine n-oder p-leitend dotierte Wanne ausgebildet ist. Auf einem ersten Teilbereich der von dem Siliziumsubstrat abgewandten Seite der Wanne ist auf dieser eine Siliziumepitaxieschicht aufgebracht, die denselben Leitungstyp wie die dotierte Wanne aber bevorzugt einen geringeren Dotierstoffgehalt als diese aufweist.

Die Siliziumepitaxieschicht ist mit einer ersten Schottky-Kontaktschicht versehen. Auf einem neben dem ersten Teilbereich liegenden zweiten Teilbereich der von dem Siliziumsubstrat abgewandten Seite der Wanne eine zweite Schottky-Kontaktschicht aufgebracht. Weiterhin ist die erste und die zweite Schottky-Kontaktschicht mit einer ersten bzw. mit einer zweiten Kontaktmetallisierung versehen.

Das hochohmige Siliziumsubstrat wirkt bei Frequenzen oberhalb 20GHz wie ein Dielektrikum und weist daher die gewünschte niedrige parasitäre Kapazität auf. Die leitend dotierte Wanne gewährleistet einen kleinen Serienwiderstand und folglich geringe elektrische Verluste der Hochfrequenzdiode. Darüber hinaus ist die erfindungsgemäße Hochfrequenzdiode auf einfache Weise mittels in der Halbleitertechnik herkömmlich verwendeten Herstellungsverfahren in Flip-Chip-Ausführung realisierbar. Zur Bestückung der Hochfrequenzdioden können herkömmliche automatisierte Bestückungsanlagen eingesetzt werden.

Bevorzugt ist die Silizium-Epitaxieschicht nicht insgesamt, sondern nur bis auf einen schmalen rahmenförmigen Randbereich von der ersten Schottky-Kontaktschicht bedeckt. Ebenso ist die zweite Schottky-Kontaktschicht bevorzugt derart auf die Wanne aufgebracht, dass ein schmaler Rahmen um die Silizium-Epitaxieschicht herum von dieser frei bleibt. Dieser nicht von den Schottky-Kontaktschichten bedeckte ringförmige Oberflächenbereich der Wanne und der Silizium-Epitaxieschicht zwischen der ersten und der zweiten Schottky-Kontaktschicht ist vorzugsweise mit einer elektrischen Isolationsschicht bedeckt. Diese rahmenförmige Isolationsschicht definiert die effektive Fläche der Hochfrequenzdiode.

Bei einer weiterhin bevorzugten Ausführungsform weist die effektive Diodenfläche in Draufsicht auf die Wanne im Wesentlichen die Form einer Kreisscheibe auf, die innerhalb eines im Wesentlichen kreisscheibenförmigen Fensters der zweiten Schottky-Kontaktschicht angeordnet ist.

Die leitend dotierte Wanne ist bevorzugt mit Arsen dotiert, wobei die Ladungsträgerkonzentration ca. 5-6*10¹⁹ cm ⁻³ beträgt. Die Siliziumepitaxieschicht ist bevorzugt mit Phosphor dotiert, 0,15 bis 0,20 µm dick und enthält beispielsweise eine Ladungsträgerkonzentration von ca. 1,5*10¹⁷cm⁻³.

Bei einem bevorzugten Verfahren zum Herstellen der erfindungsgemäßen Hochfrequenzdiode wird zunächst in einem hochohmigen Siliziumsubstrat beispielsweise mittels Implantieren eines Dotierstoffes, z. B. Arsen, durch ein Fenster einer Oxidschicht hindurch und nachfolgendem Ausdiffundieren des Dotierstoffes die dotierte Wanne hergestellt. Die Oxidschicht wird beispielsweise mittels Oxidieren und das Fenster mittels Fototechnik und anschließendem Oxidätzen hergestellt. Eine beim Ausdiffundieren entstehende Oxidschicht auf deer Substrat und auf der Wanne wird anschließend wieder entfernt.

Nachfolgend wird zumindest auf den ersten Teilbereich der Oberfläche der Wanne eine dotierte Siliziumepitaxieschicht aufgebracht, die dann, falls erforderlich, z. B. mittels Phototechnik strukturiert wird. Danach wird die elektrische Isolationsschicht auf das Siliziumsubstat, die Oberfläche der Wanne und die Siliziumepitaxieschicht aufgebracht und nachfolgend strukturiert, derart, dass der erste Teilbereich und der zweite Teilbereich für die erste Schottky-Kontaktschicht bzw. die zweite Schottky-Kontaktschicht freigelegt werden.

Nachdem der erste Teilbereich und der zweite Teilbereich mit einer ersten bzw. mit einer zweiten Metallschicht versehen werden, erfolgt ein Silizierungsschritt zum Herstellen der Schottky-Kontaktschichten. Im Anschluss daran werden nichtsilizierte Bereiche der Metallschichten beispielsweise mittels selektiver Ätzung wieder entfernt, bevor auf die erste und die zweite Schottky-Kontaktschicht eine erste bzw. eine zweite Kontaktmetallisierung aufgebracht wird.

Im Folgenden wird die erfindungsgemäße Hochfrequenzdiode anhand eines Ausführungsbeispieles in Verbindung mit den Figuren 1 bis 4f näher erläutert. Es zeigen:
Figur 1 eine schematische Darstellung einer Draufsicht auf das Ausführungsbeispiel,
Figur 2 eine schematische Darstellung eines Schnittes durch das Ausführungsbeipsiel entlang der in Figur 1 eingezeichneten Linie A-A,
Figur 3 eine schematische Darstellung einer Draufsicht auf einen Hochfrequenzdioden-Chip mit zwei Hochfrequenzdioden und
Figur 4a bis 4f eine schematische Darstellung des Verfahrensablaufes Zur Herstellung des Ausführungsbeispieles.

In den Figuren sind gleiche oder gleichwirkende Bestandteile jeweils mit denselben Bezugszeichen versehen.

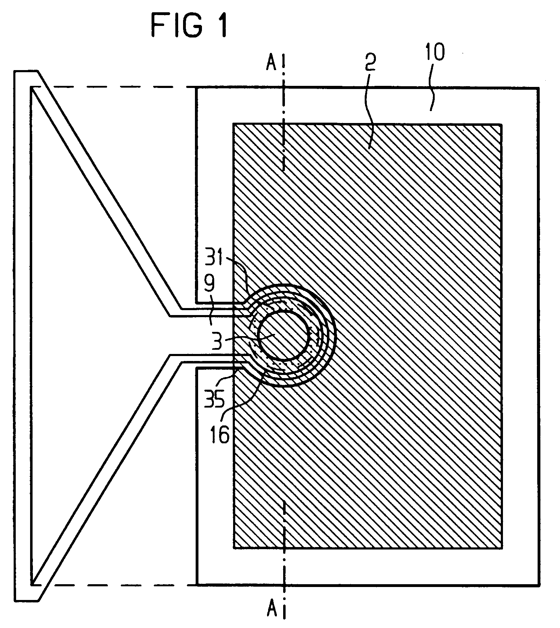

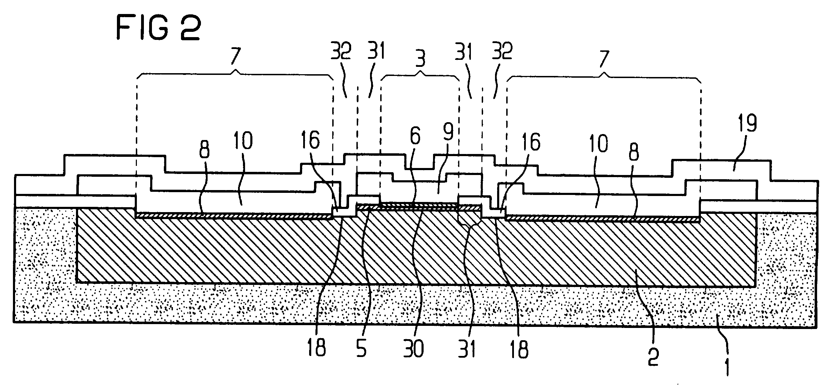

Bei dem Ausführungsbeispiel der Figuren 1 und 2 ist in einem hochohmigen Silizium-Substrat 1 eine leitend dotierte Wanne 2 ausgebildet. Das Substrat ist beispielsweise mit Bor dotiert, 100-orientiert und mit einer Dotierstoffkonzentration von 3*10¹²cm⁻³ versehen. Die Wanne 2 ist beispielsweise mit Arsen dotiert und hat einen Dotierstoffgehalt von 5-6*10¹⁹cm⁻³.

In der Wanne 2 ist eine Vertiefung 18 ausgebildet, die an der vom Siliziumsubstrat 1 abgewandten Seite der Wanne 2 eine inselartige Erhöhung 30 mit einem von dieser zum Wannenrand führenden Steg 35 begrenzt. Auf der Hauptfläche der inselartigen Erhöhung 30 der Wanne 2 ist eine Siliziumepitaxieschicht 5 aufgebracht, die beispielsweise mit Phosphor dotiert ist (Dotierstoffgehalt z. B. 1,5*10¹⁷cm⁻³) und eine Dicke zwischen 0,15 und 0,20 µm aufweist.

Auf einem im Wesentlichen kreisscheibenförmigen Diodenbereich 3 der Silizium-Epitaxieschicht 5 befindet sich eine erste Schottky-Kontaktschicht 6, wobei ein schmaler Rahmen 31 der Silizium-Epitaxieschicht 5 um den ersten Schottky-Kontakt 6 herum freigelassen ist.

Die gesamte Bodenfläche der Vertiefung 18 ist bis auf einen schmalen Randbereich 32 zum Diodenbereich 3 hin von einer zweiten Schottky-Kontaktschicht 8 bedeckt. Hierbei handelt es sich um den sogenannten Substrat-Kontaktbereich 7. Der nicht von den Schottky-Kontaktschichten 6,8 bedeckte Bereich der Oberfläche der Wanne 2 und der Silizium-Epitaxieschicht 5, also der schmale Rahmen 31 der Silizium-Epitaxieschicht 5 um den ersten Schottky-Kontakt 6 herum und der schmale Randbereich 32 der Vertiefung zum Diodenbereich 3 hin sowie die restliche außerhalb der Vertiefung 18 liegende Oberfläche der Wanne 2 und des Silizium-Substrats 1 sind mit einer elektrischen Isolationsschicht 16 überdeckt. Diese Isolationsschicht 16 definiert folglich Kontaktfenster für die Schottky-Kontaktschichten 6,8.

Auf den Schottky-Kontaktschichten 6,8 sind voneinander getrennte Kontaktmetallisierungen 9,10 aufgebracht, die an den Rändern der Schottky-Kontaktschichten 6,8 mit der angrenzenden elektrischen Isolationsschicht 16 einen Überlapp aufweisen. Die freien Oberflächen der Kontaktmetallisierungen 9,10 sowie der elektrischen Isolationsschicht 16 sind mit einer Passivierungsschicht 19, zum Beispiel eine Plasmanitrid-Schicht, bedeckt.

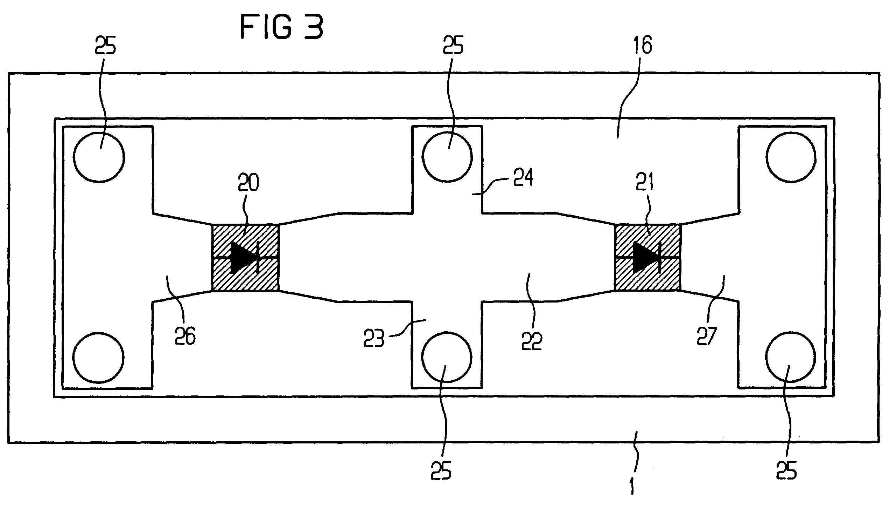

Bei dem Hochfrequenzdioden-Chip von Figur 3 sind 2 Hochfrequenzdioden gemäß dem Ausführungsbeispiel der Figuren 1 und 2 seriell verschaltet. Auf einem Silizium-Substrat 1 sind in einem Abstand zueinander zwei Diodenstrukturen 20,21 gemäß dem oben beschriebenen Ausführungsbeispiel ausgebildet, derart, dass der Anodenanschluss der zweiten Hochfrequenzdiode 21 und der Kathodenanschluss der ersten Hochfrequenzdiode 20 einander zugewandt sind. Der Kathodenanschluss der ersten Hochfrequenzdiode 20 ist über eine Leiterbahn 22, beispielsweise bestehend aus Gold, mit dem Anodenanschluss der zweiten Hochfrequenzdiode 21 verbunden. In der Mitte zwischen den beiden Hochfrequenzdioden 20,21 weist die Leiterbahn 22 Anschlussverzweigungen 23,24 auf, auf denen sich erhöhte Anschlussbereiche 25, z. B. in Form von Gold-Bumps mit einer Höhe von 10 µm, befinden. Ebenso sind der Anodenkontakt der ersten Hochfrequenzdiode 20 und der Kathodenkontakt der zweiten Hochfrequenzdiode 21 jeweils über eine Leiterbahn 26, 27 mit jeweils 2 Anschlusserhöhungen 25 elektrisch leitend verbunden. Die Leiterbahnen 22, 23, 24, 26, 27 sowie die Diodenstrukturen sind vollständig mit der Passivierungsschicht 19 bedeckt. Lediglich die Anschlusserhöhungen 25 ragen aus dieser heraus.

Bei dem in den Figuren 4a bis 4f schematisch dargestellten Verfahrensablauf zur Herstellung der Hochfrequenzdiode gemäß dem Ausführungsbeispiel wird zunächst an einer Hauptfläche 28 eines hochohmigen Silizium-Substrats 1, beispielsweise Bordotiert (Dotierstoffgehalt ca. 3*10¹²cm⁻³) und 100-orientiert, eine Oxidschicht 29 ausgebildet, die nachfolgend mittels Fototechnik und Oxidätzen mit einem Fenster 33 versehen wird, das die Form der Wanne 2 definiert. Danach wird durch das Fenster 33 hindurch ein n-Dotierstoff, z. B. Arsen, in das Silizium-Substrat 1 implantiert 14 (Figur 4a).

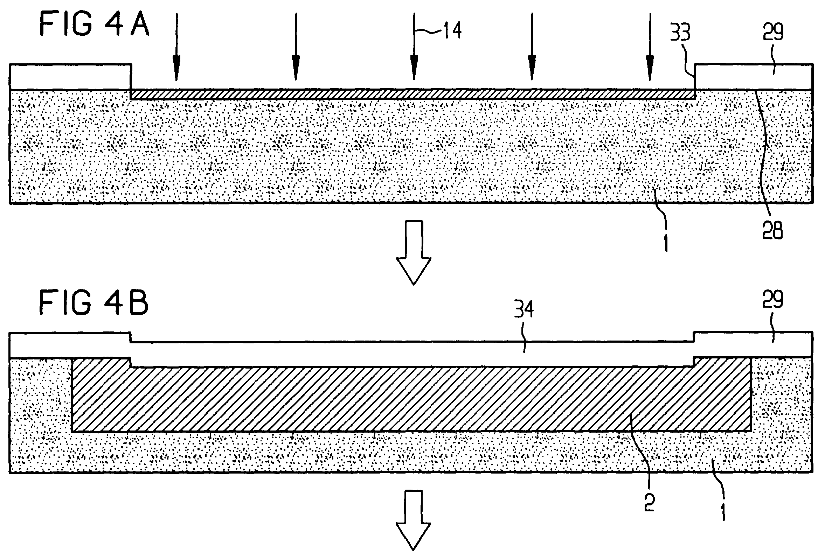

Nachfolgend (Figur 4b) wird die Implantation mittels Tempern ausdiffundiert, so dass im Silizium-Substrat 1 eine leitend dotierte Wanne 2 entsteht. Diese Wanne 2 weist beispielsweise einen Arsen-Gehalt von ca. 5*10¹⁹cm⁻³ auf. Bei diesem Temperschritt entsteht auf der Wanne 2 eine Oxidschicht 34, die nachfolgend mittels Oxidätzen zusammen mit der Oxidschicht 29 entfernt wird.

Als nächster Schritt wird auf der Wanne 2 eine beispielsweise mit Phosphor n-leitend dotierte Silizium-Epitaxieschicht aufgebracht, die ca. 0,2 µm dick ist und einen Dotierstoffgehalt von etwa 1,5*10¹⁷ cm⁻³ aufweist. Nachfolgend wird beispielsweise mittels Fototechnik und Silizium-Plasmaätzen die Silizium-Epitaxieschicht strukturiert und die Vertiefung 18 hergestellt, derart, dass nur noch die Erhöhung 30 mit der Silizium-Epitaxieschicht 5 versehen ist und dieser Bereich von der Vertiefung 18 begrenzt ist. Ein Randbereich 32 der Vertiefung 18 zum Diodenbereich 3 hin und ein schmaler Rahmen der Erhöhung 30 sowie die restliche außerhalb der Vertiefung 18 liegende Oberfläche der Wanne 2 und des Silizium-Substrats 1 werden mit einer elektrischen Isolationsschicht 16 versehen. Diese wird bevorzugt mittels eines Niedertemperatur-Oxidabscheidungsprozesses hergestellt, um eine Diffusion des Dotierstoffes der Wanne 2 in die Silizium-Epitaxieschicht 5 zu verhindern. Dazu wird zunächst auf die gesamte Oberfläche der Wanne 2, der Silizium-Epitaxieschicht 5 im Diodenbereich 3 eine Niedertemperatur-Oxidschicht z. b. mit einer Dicke von ca. 0,6 µm abgeschieden, und anschließend mittels Fototechnik und Oxidätzen mit den Fenstern für die erste und die zweite Schottky-Kontaktschicht 6,8 versehen. Danach liegt die in Figur 4c schematisch dargestellte Struktur mit Oxidschichtfenstern für die Schottky-Kontaktschichten 6,8 vor.

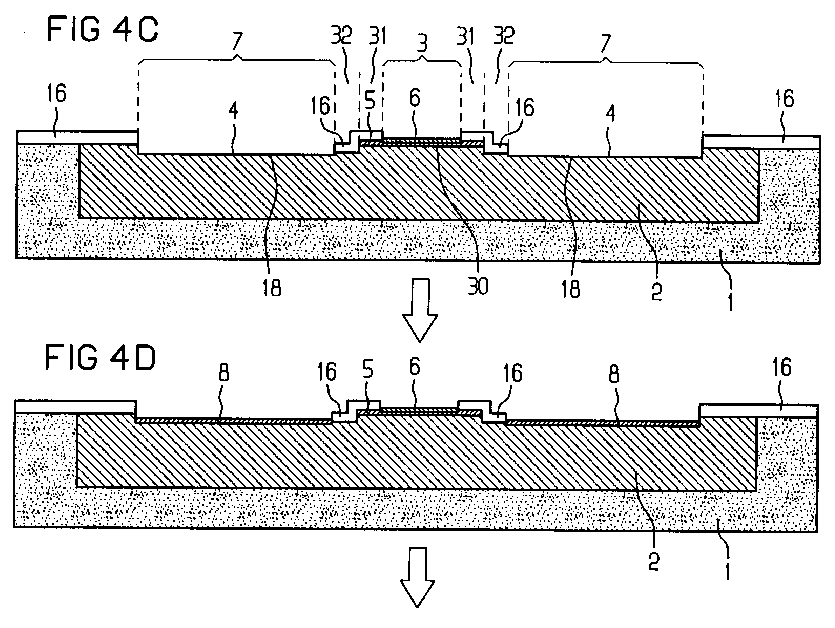

Nun wird auf die freien Oberflächen der Wanne 2 und der Silizium-Epitaxieschicht 5 durch die Oxidschicht-Fenster hindurch eine Schottky-Metallschicht, z. B. Pd oder Mo, abgeschieden. Nachfolgend wird im Bereich der Oxidschicht-Fenster dieses Schottky-Metall mittels Temperatur-Behandlung siliziert. Ein nichtsilizierter Rest der Schottky-Metallschicht wird dann mittels selektiver Ätzung wieder entfernt, so dass im Diodenbereich 3 und in der Vertiefung 18 jeweils eine Schottky-Kontaktschicht 6,8 auf der Silizium-Epitaxieschicht 5 bzw. auf der Wanne 2 verbleibt (Figur 4d).

Als nächster Schritt werden auf die Schottky-Kontaktschichten 6,8 voneinander getrennte Kontakt-Metallisierungen 9,10 aufgebracht, die jeweils einen Überlapp mit der an die Schottky-Kontaktschichten 6,8 angrenzenden Isolationsschicht 16 aufweisen. Die Kontakt-Metallisierungen 9,10 bestehen beispielsweise aus einer TiPtAu-Schichtfolge (BELL-Kontakt), die zunächst auf die gesamte Oberfläche der Schottky-Kontaktschichten 6,8 und der Isolationsschicht 16 aufgebracht und nachfolgend entsprechend der gewünschten Form der Kontakt-Metallisierungen 9,10 mittels Fototechnik strukturiert werden kann. Die entsprechende Struktur ist in Figur 4e dargestellt.

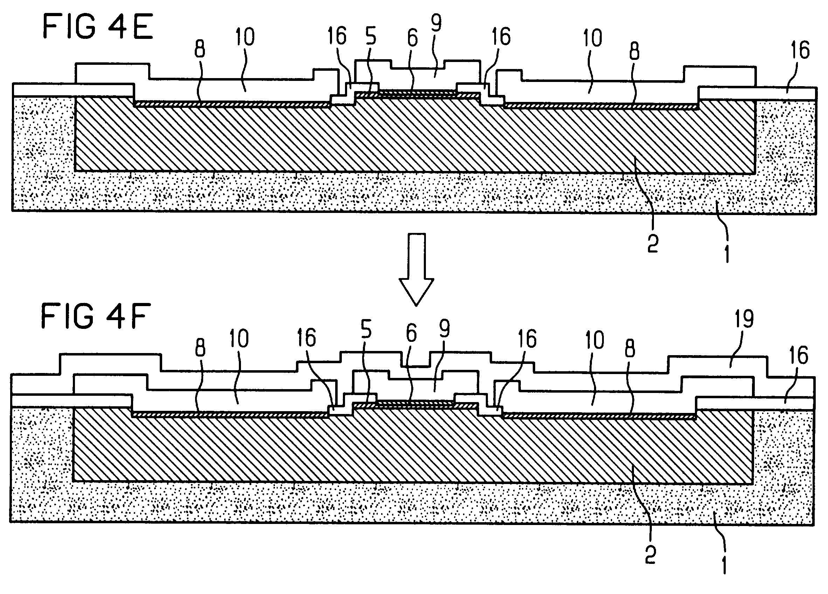

Abschließend wird auf die freien Oberflächen der Kontakt-Metallisierungen 9,10 und der Isolationsschicht 16 eine Passivierungsschicht 19, z. B. in Form einer Plasmanitrid-Schicht, aufgebracht (Figur 4f).

Die Beschreibung der erfindungsgemäßen Hochfrequenzdiode anhand des Ausführungsbeispieles ist selbstverständlicherweise nicht als Einschränkung der Erfindung auf dieses zu verstehen. Anstelle der Oxidschicht 16 kann beispielsweise auch eine andere dem Fachmann bekannte elektrische Isolationsschicht verwendet werden. Ebenso können anstelle der n-Dotierstoffe Arsen und Phosphor auch andere n-Dotierstoffe oder auch p-Dotierstoffe für die leitend-dotierte Wanne 2 und die Silizium-Epitaxieschicht 5 verwendet sein. Ebenso sind auch andere Schottky-Kontaktschichten und Kontakt-Metallisierungen denkbar.

## Patentansprüche

1. Hochfrequenzdiode, bei der
- in einem hochohmigen Siliziumsubstrat (1) eine n- oder p-leitend dotierte Wanne (2) ausgebildet ist,
- über einem ersten Teilbereich (3) einer Oberfläche (4) der Wanne (2) eine Silizium-Epitaxieschicht (5) vorgesehen ist, die denselben Leitungstyp wie die dotierte Wanne (2) aufweist,
- die Silizium-Epitaxieschicht (5) mit einer ersten Schottky-Kontaktschicht (6) versehen ist,
- ein neben dem ersten Teilbereich (3) liegender zweiter Teilbereich (7) der Oberfläche (4) der Wanne (2) mit einer zweiten Schottky-Kontaktschicht (8) versehen ist und
- bei der die erste und die zweite Schottky-Kontaktschicht(6,8) mit einer ersten (9) bzw. mit einer zweiten Kontaktmetallisierung (10) versehen sind.

2. Hochfrequenzdiode nach Anspruch 1, bei der das Siliziumsubstrat 1 einen spezifischen Widerstand von größer als 3 kΩcm aufweist.

3. Hochfrequenzdiode nach Anspruch 1 oder 2, bei der die Siliziumepitaxieschicht 5 einen geringeren Dotierstoffgehalt als die Wanne 2 aufweist.

4. Hochfrequenzdiode nach einem der Ansprüche 1 bis 3, bei der zwischen der ersten (6) und der zweiten Schottky-Kontaktschicht (8) eine elektrische Isolationsschicht (16) angeordnet ist, die einen Randbereich (32) der Oberfläche (4) der Wanne (2) zur Silizium-Epitaxieschicht (5) hin und einen schmalen um den ersten Schottky-Kontakt (6) umlaufenden Bereich (31) der Oberfläche der der Silizium-Epitaxieschicht (5) bedeckt.

5. Hochfrequenzdiode nach einem der Ansprüche 1 bis 4, bei der in Draufsicht auf die Wanne (2) der erste Teilbereich (3) im Wesentlichen die Form einer Kreisscheibe aufweist, die innerhalb einer im Wesentlichen kreisscheibenförmigen Aussparung der zweiten Schottky-Kontaktschicht (8) angeordnet ist und von der aus ein gegen die Wanne (2) elektrisch isolierter Steg (35) aus dem Bereich der Wanne (2) herausführt.

6. Verfahren zum Herstellen einer Hochfrequenzdiode nach einem der Ansprüche 1 bis 5 mit folgenden Verfahrensschritten:
a) Herstellen des hochohmigen Siliziumsubstrats (1),
b) Herstellen der dotierten Wanne (2) im Siliziumsubstrat (1) mittels Implantieren (14) eines n- oder p-Dotierstoffes in einen Teilbereich des Siliziumsubstrats (1) und nachfolgendem Ausdiffundieren des Dotierstoffes,
c) Herstellen der n- bzw. p-dotierten Siliziumepitaxieschicht (5) auf der Oberfläche (4) der Wanne (2),
d) Strukturieren der Siliziumepitaxieschicht (3),
e) Aufbringen einer elektrischen Isolationsschicht (16) auf das Siliziumsubstrat (1), die Wanne (2) und die Siliziumepitaxieschicht (5),
f) Strukturieren der elektrischen Isolationsschicht (16), derart, dass der erste Teilbereich (3) und der zweite Teilbereich (7) freigelegt werden,
g) Aufbringen einer ersten und einer zweiten Metallschicht auf den ersten bzw. den zweiten Teilbereich (3,7),
h) Silizieren der Metallschichten zum Herstellen der Schottky-Kontaktschichten (6,8) und
i) Aufbringen der ersten (9) und der zweiten Kontaktmetallisierung (10) auf die erste bzw. zweite Schottky-Kontaktschicht (6,8).
